Europäisches Patentamt

European Patent Office

Office européen des brevets

(11) Veröffentlichungsnummer: **0 345 702**
**A2**

## EUROPÄISCHE PATENTANMELDUNG

(21) Anmeldenummer: **89110151.1**

(22) Anmeldetag: **05.06.89**

(51) Int. Cl.⁴: **G01R 31/28**

(30) Priorität: **08.06.88 DE 3819489**

(43) Veröffentlichungstag der Anmeldung:
**13.12.89 Patentblatt 89/50**

(84) Benannte Vertragsstaaten:
**DE FR GB NL**

(71) Anmelder: **Siemens Aktiengesellschaft**
**Wittelsbacherplatz 2**
**D-8000 München 2(DE)**

(72) Erfinder: **Quincke, Jörg, Dipl.-Ing.**
**Passauerstrasse 6**
**D-8000 München 70(DE)**
Erfinder: **Plies, Jörg, Dr. rer. nat.**
**Deisenhofener Strasse 79 c**
**D-8000 München 90(DE)**

(54) **Verfahren zur Untersuchung der Latch-Up-Ausbreitung in CMOS-Schaltungen.**

(57) Für den Entwickler mikroelektronischer Bauelemente ist die Kenntnis der Latch-Up-Ausbreitung in integrierten CMOS-Schaltungen von entscheidender Bedeutung, um deren Latch-Up-Empfindlichkeit durch eine Änderung des Designs oder technologische Maßnahmen verringern zu können. Da die bekannten Verfahren zur Untersuchung der Latch-Up-Ausbreitung nur eine vergleichsweise geringe zeitliche Auflösung besitzen, wird vorgeschlagen, den Latch-Up periodisch auszulösen, die Intensität der von der Schaltung ausgehenden Infrarotstrahlung nacheinander an mehreren die Schaltung rasterförmig überdeckenden Meßstellen zu einem vorgegebenen Zeitpunkt $\tau$ nach dem Auftreten des den Latch-Up auslösenden Triggersignals abzutasten und jeweils einen die Intensität $I(\tau)$ repräsentierenden Meßwert ortsabhängig aufzuzeichnen.

FIG 2

EP 0 345 702 A2

# Verfahren zur Untersuchung der Latch-Up-Ausbreitung in CMOS-Schaltungen.

Die Erfindung bezieht sich auf ein Verfahren zur Untersuchung der Latch-Up-Ausbreitung in CMOS-Schaltungen nach dem Oberbegriff des Patentanspruchs 1 sowie auf eine Anordnung zur Durchführung des Verfahrens.

In integrierten CMOS-Schaltungen existieren immer parasitäre Thyristorstrukturen, deren Zündung infolge der damit einhergehenden Aufheizung der Strompfade zu einer Zerstörung des Bauelementes führen kann. Prinzipiell läßt sich der als Latch-Up bezeichnete Effekt am sprunghaften Anstieg und der Selbsthaltung des Versorgungsstroms erkennen, ohne allerdings die betroffen Schaltungsteile identifizieren und durch eine Änderung des Designs oder technologische Maßnahmen (höhere Wannen-und Substratdotierungen, Verwendung einer niederohmigen Epitaxieschicht usw.) verbessern zu können. Es wurden deshalb eine Reihe von Verfahren zur Lokalisierung Latch-Up-empfindlicher Bereiche in integrierten CMOS-Schaltungen entwickelt (siehe beispielsweise VDI-Berichte Nr. 659 (1987), Seite 381 bis 393, Siemens Forschungs- und Entwicklungsberichte Band 13 (1984) Nr. 1, Seite 9 bis 14 und IEEE IRPS = International Reliability Physics Symposium 1984, Seite 122 bis 127). Hierbei bietet das aus IEEE IRPS bekannte Verfahren insbesondere den Vorteil, daß auch die mit konventionellen Flüssigkristalltechniken nicht lokalisierbaren primären Latch-Up-Zentren indentifiziert werden können.

Der Erfindung liegt die Aufgabe zugrunde, ein Verfahren der eingangs genannten Art anzugeben, mit dem die Latch-Up-Ausbreitung in CMOS-Schaltungen mit hoher örtlicher und zeitlicher Auflösung untersucht werden kann. Weiterhin soll eine Anordnung zur Durchführung des Verfahrens angegeben werden.

Diese Aufgaben werden erfindungsgemäß durch ein Verfahren nach Patentanspruch 1 sowie durch eine Anordnung nach Patentanspruch 7 gelöst.

Der mit der Erfindung erzielbare Vorteil besteht insbesondere darin, daß die Latch-Up-Ausbreitung in CMOS-Schaltungen mit hoher zeitlicher und örtlicher Auflösung untersucht werden kann.

Während die Ansprüche 2 bis 6 bevorzugte Ausgestaltungen des Verfahrens nach Anspruch 1 betreffen, sind die Ansprüche 8 bis 11 auf Weiterbildungen der Anordnung zur Durchführung des Verfahrens gerichtet.

Die Erfindung wird im folgenden anhand der Zeichnungen näher erläutert. Hierbei zeigt

Figur 1 den schematischen Aufbau eines Raster-Laser-Mikroskops

Figur 2 ein Ausführungsbeispiel einer Anordnung zur Durchführung des erfindungsgemäßen Verfahrens

Figur 3 die Zeitabhängigkeit einiger innerhalb der erfindungsgemäßen Anordnung auftretenden Signale und

Figur 4 ein zweites Ausführungsbeispiel einer Anordnung zur Durchführung des Verfahrens.

Bei dem aus IEEE IRPS bekannten Verfahren wird die Latch-Up-Ausbreitung in CMOS-Bausteinen durch Nachweis der von der Schaltung emittierten Infrarotstrahlung untersucht. Von besonderer Bedeutung ist hierbei die infolge der elektrischen Aufheizung der Thyristorstrukturen entstehende Wärmestrahlung mit einem Intensitätsmaximum bei $\lambda$ = 8 bis 10 $\mu$m und die durch Rekombination überschüssiger Elektronen-Loch-Paare erzeugte Infrarotstrahlung mit einem Intensitätsmaximum bei $\lambda$ = 1,1 $\mu$m, die vorzugsweise im Bereich der in Durchlaßrichtung gepolten p-n-Übergänge auftritt. Um die Latch-Up-Ausbreitung in CMOS-Schaltungen mit hoher örtlicher und zeitlicher Auflösung in einem vorgeschlagen:

- eine parasitäre Thyristorstruktur der Schaltung gesteuert durch ein Triggersignal periodisch zu zünden,
- die Intensität der Rekombinations- und/oder Wärmestrahlung (im folgenden kurz als Infrarotstrahlung bezeichnet) nacheinander an mehreren die Schaltung vorzugsweise rasterförmig überdeckenden Meßstellen zu einem vorgegebenen Zeitpunkt $\tau$ nach dem Auftreten des den Latch-Up auslösenden Triggersignals abzutasten,
- an den Meßstellen jeweils einen die zum Zeitpunkt $\tau$ gemessene Intensität I($\tau$) repräsentierenden Meßwert aufzuzeichnen
- und gegebenenfalls ein Bild der Schaltung zu erzeugen, wobei die Intensität I($\tau$) der Infrarotstrahlung die Helligkeit der den Meßstellen jeweils zugeordneten Bildpunkte bestimmt.

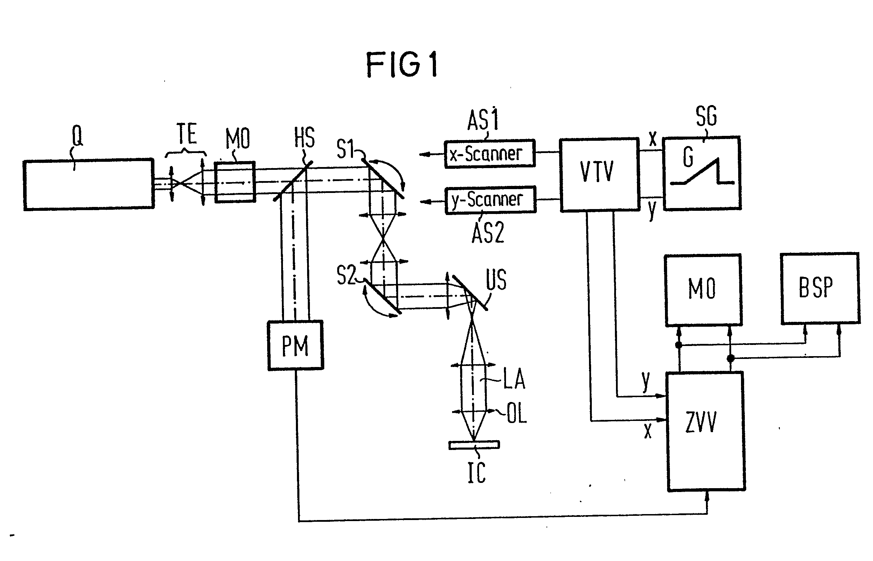

Zur Durchführung des erfindungsgemäßen Verfahrens kann man beispielsweise das aus Scanning Vol. 7 (1985), Seiten 88 bis 96, bekannte Raster-Laser-Mikroskop verwenden, dessen schematischer Aufbau in Figur 1 dargestellt ist. Es umfaßt eine Laserquelle Q (Helium-Neon-Laser), ein Teleskop TE zur Aufweitung des Laserstrahls LA, einen akustooptischen Modulator MO, einen halbdurchlässigen Spiegel HS, eine aus zwei hochgenauen Galvanometerspiegeln S1 und S2 bestehende Ablenkeinheit, einen Umlenkspiegel US und eine Objektivlinse OL zur Fokussierung des Laserstrahls LA auf die Probe IC, vorzugsweise eine integrierte CMOS-Schaltung. Außerdem ist das Raster-Laser-Mikroskop noch mit einer in Figur 1 nicht näher bezeichneten telezentrischen Optik ausgestattet, die sicherstellt, daß der Laserstrahl LA in der Objektivpupille örtlich ruht und somit nur eine Winkelbewegung mit der Pupille als Drehpunkt ausführt. Unabhängig von der Stellung der um orthogonale Achsen drehbaren Galvanometerspiegel S1 und S2 wird somit immer die volle Öffnung der Objektivlinse OL ausgenutzt, wobei die Strahlfleckgröße auf der Probe IC unabhängig ist vom Ort des Fokus in der Ebene der Probenoberfläche.

Die die Position des Laserstrahls LA auf der Probe IC definierenden Ablenkspannungen werden in einem hochgenauen Rastergenerator SG erzeugt und in einem Tandemverstärker VTV verstärkt, dessen Ausgangssignale an den Eingängen der den Spiegeln S1 und S2 zugeordneten Ansteuereinheiten AS1 und AS2 anliegen. Zur Erzeugung eines Auflichtbildes der Probe IC wird die in die Objektivlinse OL rückgestreute und mit Hilfe des halbdurchlässigen Spiegels HS ausgekoppelte Strahlung mit einem Photomultiplier PM nachgewiesen, dessen verstärktes Ausgangssignal die Intensität des Schreibstrahls eines Monitors MO steuert. Dem Monitor MO ist vorzugsweise ein Videoverstärker ZVV vorgeschaltet, an dessen Eingängen sowohl das Ausgangssignal des Photomultipliers PM als auch die den Ort des Laserstrahls LA auf der Probe IC repräsentierenden Ausgangssignale des Tandemverstärkers VTV anliegen. Die Meßdaten (Koordinaten der Meßstelle auf der Probe IC, Intensität der rückgestreuten Strahlung usw.) werden üblicherweise in einem dem Monitor MO zugeordneten Bildspeicher BSP abgelegt, um diese nach der Messung darstellen und auswerten zu können.

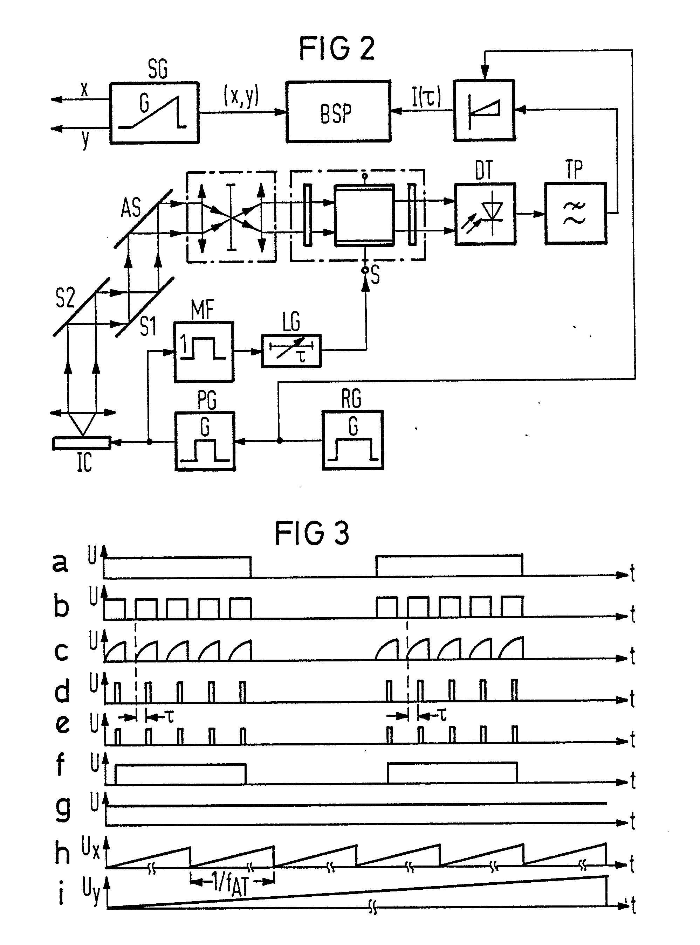

Zur Durchführung des erfindungsgemäßen Verfahrens ist das Raster-Laser-Mikroskop zusätzlich noch mit einem in den Strahlengang einbringbaren Umlenkspiegel AS ausgestattet (siehe Figur 2, in der nur die für die Durchführung des Verfahrens wesentlichen Komponenten des Raster-Laser-Mikroskops dargestellt sind), mit dem man die von der jeweiligen Meßstelle ausgehende Infrarotstrahlung IR auskoppelt und einem Detektor DT zuführt. Die Lage der Meßstelle auf der Probenoberfläche wird hierbei mit Hilfe der die Stellung der Spiegel S1 bzw. S2 definierenden Ablenkspannung des Rastergenerators SG vorgegeben. So liegen die Meßstellen rasterförmig über die Probenoberfläche verteilt, wenn man die Ansteuereinheiten AS1 und AS2 der Spiegel S1 bzw. S2 mit den in Figur 3h, i dargestellten sägezahnförmigen Signalen beaufschlagt.

Die ausgekoppelte Infrarotstrahlung IR durchläuft einen aus zwei Linsen und einer Lochblende (Blendendurchmesser wenige μm) bestehenden Raumfilter RF (Unterdrückung der Stör- und Untergrundstrahlung) und einen elektrooptischen Modulator EOM, beispielsweise eine zwischen zwei Polarisatoren angeordnete Pockelszelle, um anschließend mit einer stickstoffgekühlten Germanium-Pin-Diode nachgewiesen zu werden. Dem Detektor DT ist ein Tiefpaßfilter TP nachgeschaltet, dessen Ausgangssignal am Eingang eines Lock-in-Verstärkers LIV anliegt. Dieser ist ausgangsseitig mit einem Dateneingang des Bildspeichers BSP verbunden, dessen zweiter Eingang die Koordinaten der jeweiligen Meßstelle vom Rastergenerator SG übernimmt.

In der zu untersuchenden Probe IC, wird der Latch-Up durch die gepulste Versorgungsspannung periodisch ausgelöst und unterdrückt. Die Elektronik zur Ansteuerung der Probe IC besteht deshalb aus einem das Latch-Up-Triggersignal erzeugenden Impulsgenerator PG (Impulswiederholfrequenz $f_{PG}$ = 100 kHz - 1 MHz) und einem Rechteckgenerator RG (Impulswiederholfrequenz $f_{RG} \ll f_{PG}$), dessen Ausgangssignal sowohl am Steuereingang des Impulsgenerators PG als auch am Referenzeingang des Lock-in-Verstärkers LIV anliegt. Die Impulswiederholfrequenz $f_{RG}$ des Rechteckgenerators RG ist hierbei so gewählt, daß diese die Frequenz $f_{AT}$ (Abtastrate) des die Zeilenablenkung bestimmenden Ausgangssignals des Rastergenerators SG um mindestens eine bis zwei Größenordnungen übertrifft ($f_{AT} \approx$ 100 kHz - 1 kHz, $f_{RG} \approx$ 10 kHz).

Da man die Intensität I(t) der Infrarotstrahlung IR an der jeweiligen Meßstelle nur zu einem vorgegebenen Zeitpunkt $\tau$ nach dem Zünden der parasitären Thyristorstruktur abtastet, ist die Meßelektronik des Raster-Laser-Mikroskops mit einer ein Zeitfenster definierenden Schaltung MF'LG ausgestattet, deren Ausgangssignal am Steuereingang S des elektrooptischen Modulators EOM anliegt. Diese Schaltung umfaßt ein flankengesteuertes Monoflop MF und ein einstellbares Verzögerungsglied LG, wobei das Verzögerungsglied LG die Lage des Zeitfensters bezüglich des am Eingang der Schaltung liegenden Ausgangssignals des Impulsgenerators PG (Latch-Up-Triggersignal) bestimmt und die Zeitkonstante des Monoflops MF die Breite des Zeitfensters festlegt.

Die Zeitabhängigkeit einiger innerhalb der beschriebenen Meßanordnung auftretenden Signale ist schematisch in Figur 3 dargestellt. Hierbei zeigt

Figur 3a) das Ausgangssignal des Rechteckgenerators RG (Frequenz $f_{RG}$),

Figur 3b) das Ausgangssignal des Impulsgenerators PG (Frequenz $f_{PG}$),

Figur 3c) die Intensität I(t) der Infrarotstrahlung IR,

Figur 3d) das Ausgangssignal des Verzögerungsgliedes LG,

Figur 3e) das Detektorausgangssignal,

Figur 3f) das Ausgangssignal des Tiefpasses TP ($f_{RG} < f_G \ll f_{PG}$, $f_G$ = Grenzfrequenz des Tiefpasses TP).

Figur 3g) das die Intensität I(t) der Infrarotstrahlung IR repräsentierende Ausgangssignal des Lock-in-Verstärkers LIV mit der Bandbreit $\Delta f = \pm f_{AT}$.

Figur 3h) das Ausgangssignal der Ansteuereinheit AS1 (x-Ablenkung, Abtastffrequenz $f_{AT}$) und

Figur 3i) das Ausgangssignal der Ansteuereinheit AS2 (y-Ablenkung).

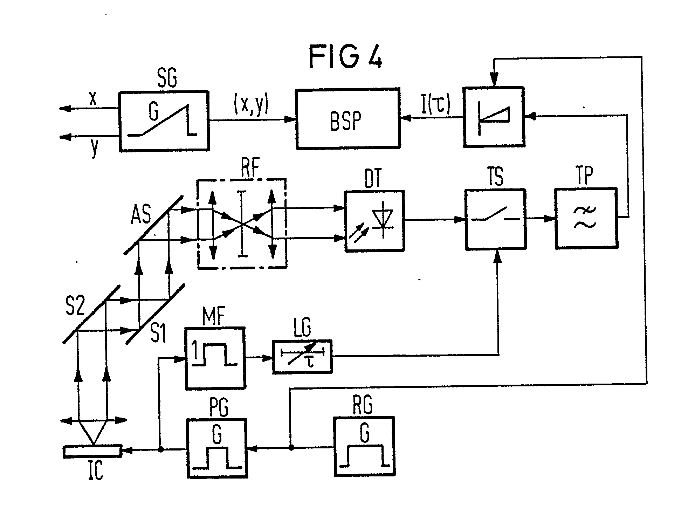

Ein zweites Ausführungsbeispiel einer Anordnung zur Durchführung des erfindungsgemäßen Verfahrens ist schematisch in Figur 4 dargestellt. Diese unterscheidet sich von der Anordnung nach Figur 2 durch einen im Signalweg zwischen dem Detektor DT und dem Tiefpaßfilter TP angeordneten Analogschalter TS, der den elektrooptischen Modulator EOM ersetzt. Die das Zeitfenster definierende Schaltung besteht wiederum aus einem Monoflop MF und einem Verzögerungsglied LG, dessen Ausgangssignal am Steuereingang des Analogschalters TS anliegt. Im übrigen bleibt der Aufbau der Meßelektronik unverändert.

Nach Beendigung der Messung kann man ein Bild der Probe IL auf dem Monitor MO des Raster-Laser-Mikroskops erzeugen, wobei der die Intensität I(τ) repräsentierende Meßwert die Helligkeit der den Meßstellen jeweils zugeordneten Bildpunkte bestimmt. Das Monitorbild zeigt dann den Zustand der Latch-up-Ausbreitung zum Zeitpunkt τ.

Die Erfindung ist selbstverständlich nicht auf die beschriebenen Ausführungsbeispiele beschränkt. So ist es ohne weiteres möglich, eine parasitäre Thyristorstruktur auch durch einen auf einen Latch-Up empfindlichen Bereich der Schaltung IC gerichteten Laser- oder Elektronenstrahl zu zünden.

Auf den die Breite des Zeitfensters definierenden Monoflop MF und das Verzögerungsglied LG kann verzichtet werden, wenn man einen Zweikanalimpulsgenerator PG, beispielsweise das Modell SPG der Firma Wavetek, zur Ansteuerung der Probe IC verwendet.

Es ist selbstverständlich auch möglich, die ausgekoppelte Infrarotstrahlung mit Hilfe eines wellenlängenabhängigen Strahlfilters in zwei die Rekombinationstrahlung ($\lambda \approx 1{,}1 \ \mu m$) und die Wärmestrahlung ($\lambda \approx 8 - 10 \ \mu m$) repräsentierende Teilstrahlen aufzuspalten und deren Intensität jeweils in einem für die betreffende Strahlung empfindlichen Detektor zu messen.

Ansprüche

1. Verfahren zur Untersuchung der Latch-Up-Ausbreitung in CMOS-Schaltungen durch Nachweis der von der Schaltung emittierten Infrarotstrahlung (IR), **dadurch gekennzeichnet,**
- daß der Latch-Up periodisch ausgelöst wird,
- daß die Intensität (I) der Infrarotstrahlung (IR) nacheinander an mehreren Meßstellen jeweils zu einem vorgegenen Zeitpunkt (τ) nach dem Auslösen des Latch-Up bestimmt wird,
- und daß an den Meßstellen jeweils ein die gemessene Intensität I(τ) repräsentierender Meßwert ortsabhängig aufgezeichnet wird.

2. Verfahren nach Anspruch 1, **dadurch gekennzeichnet,** daß ein Bild der Schaltung erzeugt wird, wobei die Intensität (I(τ)) der Infrarotstrahlung (IR) die Helligkeit der den Meßstellen jeweils zugeordneten Bildpunkte bestimmt.

3. Verfahren nach Anspruch 1 oder 2, **dadurch gekennzeichnet,** daß der Latch-Up durch einen auf die Schaltung (IC) gerichteten Korpuskularstrahl (LA) ausgelöst wird.

4. Verfahren nach Anspruch 1 oder 2, **dadurch gekennzeichnet,** daß der Latch-Up durch ein elektrisches Triggersignal ausgelöst wird.

5. Verfahren nach Anspruch 1, **dadurch gekennzeichnet,** daß das verzögerte Triggersignal ein Zeitfenster zur Messung der Intensität (I(τ)) der Infrarotstrahlung (IR) bestimmt.

6. Verfahren nach einem der Ansprüche 1 bis 5, **dadurch gekennzeichnet,** daß die Meßstellen die Schaltung (IC) rasterförmig überdecken.

7. Anordnung zur Durchführung des Verfahrens nach Anspruch 1, **gekennzeichnet durch**
- ein Linsensystem (OL) zur Bündelung der von der Meßstelle ausgehenden Infrarotstrahlung (IR),
- eine von einem Rastergenerator (SG) angesteuerte Ablenkeinheit (S1, S2), wobei die Ausgangssignale des Rastergenerators (SG) den Ort der jeweiligen Meßstelle innerhalb der Schaltung (IC) bestimmen,
- eine Einrichtung (PG, RG) zur Erzeugung eines den Latch-Up auslösenden Triggersignals,
- einen Detektor (DT) zum Nachweis der Infrarotstrahlung (IR),
- eine Einrichtung (EOM, TS, MF, LG) zur Erzeugung eines Zeitfensters,
- eine Meßelektronik (TP, LIV) zur Erzeugung eines die Intensität (I) der Infrarotstrahlung (IR) repräsentierenden Meßwertes,
- und eine Einheit (BSP) zur Speicherung der Meßwerte.

8. Anordnung nach Anspruch 7, **dadurch gekennzeichnet,** daß die Einrichtung zur Erzeugung des Triggersignals einen Impulsgenerator (PG) und einen den Impulsgenerator (PG) ansteuernden Rechteckgenerator (RG) aufweist.

9. Anordnung nach Anspruch 7 oder 8, **dadurch gekennzeichnet,** daß die Einrichtung zur Erzeugung eines Zeitfensters aus einem eingangsseitig mit dem Ausgangssignal des Impulsgenerators (PG) beaufschlagten Monoflop (MF), einem Verzögerungsglied (LG) und einem von diesem angesteuerten optischen Modulator (EOM) besteht, wobei der Modulator (EOM) im Strahlengang vor dem Detektor (DT) angeordnet ist.

10. Anordnung nach Anspruch 7 oder 8, **dadurch gekennzeichnet,** daß die Einrichtung zur Erzeugung des Zeitfensters aus einem eingangsseitig mit dem Ausgangssignal des Impulsgenerators (PG) beaufschlagten Monoflop (MF), einem Verzögerungsglied (LG) und einer von diesem angesteuerten Torschaltung (TS) besteht, wobei die Torschaltung (TS) mit einem die gemessene Intensität (I($\tau$)) repräsentierenden Signal beaufschlagt ist.

11. Anordnung nach einem der Ansprüche 7 bis 9, **dadurch gekennzeichnet,** daß die Meßelektronik aus einem Tiefpaß (TP) und einem Lock-in-Verstärker (LIV) besteht, wobei ein Referenzeingang des Lock-in-Verstärkers (LIV) mit dem Ausgangssignal des Rechteckgenerators (RG) beaufschlagt ist.

FIG1

# FIG 2

# FIG 3

# FIG 4